# NEUE EUROPÄISCHE PATENTSCHRIFT

(11) **EP 2 865 252 B2**
(45) Veröffentlichungstag und Bekanntmachung des Hinweises auf die Entscheidung über den Einspruch: **24.04.2019**
(45) Hinweis auf die Patenterteilung: 24.08.2016
(21) Anmeldenummer: 13731145.2
(22) Anmeldetag: 25.06.2013
(51) Int. Cl.: H05K 7/14, H01R 9/24, H01R 13/447

(54) **ELEKTRONIKGERÄTEGEHÄUSE**
ELECTRONICS DEVICE HOUSING
BOÎTIER D'APPAREIL ÉLECTRONIQUE

(30) Priorität: 25.06.2012 DE 202012102325 U
(43) Veröffentlichungstag der Anmeldung: 29.04.2015
(73) Patentinhaber: Wago Verwaltungsgesellschaft mbH, 32423 Minden (DE)
(72) Erfinder: BINNER, Lars, 49326 Melle (DE)
(74) Vertreter: Gerstein, Hans Joachim
(86) Internationale Anmeldenummer: PCT/EP2013/063266
(87) Internationale Veröffentlichungsnummer: WO 2014/001329

(56) Entgegenhaltungen:
- EP-A1- 1 513 385
- EP-A2- 2 110 894
- EP-B1- 1 912 285
- DE-U1- 29 606 735
- DE-U1- 29 606 759
- DE-U1-202009 002 498
- US-B1- 6 811 425

## Beschreibung

Die Erfindung betrifft ein Elektronikgerätegehäuse und ein Set von Zubehörteilen umfassend Auswerferelemente und Verriegelungselemente, wobei das Elektronikgerätegehäuse zwei voneinander beabstandete Seitenwandelemente zur Bildung eines Gehäuses mit einem Gehäuseinnenraum zur Aufnahme mindestens einer Leiterplatte hat, und wobei an mindestens einer der Stirnseiten im Zwischenraum zwischen den Seitenwandelementen mindestens ein Montageplatz für Leiteranschluss-Steckverbinder vorgesehen ist.

Derartige Elektronikgerätegehäuse sind von diversen Herstellern in verschiedenen Ausführungsformen bekannt. Sie dienen insbesondere zur Bereitstellung eines zunächst universellen Systems, das von Nutzern durch geeignete Auswahl der verfügbaren Systemkomponenten und Bestückung mit Steckverbindern und Gegensteckverbindern an den individuellen Bedarf anpassbar ist. Damit lässt sich auf einfache und preiswerte Weise ein individuell angepasstes Elektronikgerätegehäuse aus einem universellen System, bestehend aus verschiedenen Systemkomponenten einschließlich der Seitenwandelemente eines Elektronikgerätegehäuses schaffen.

EP 2 120 296 A1 offenbart ein anreihbares Elektronikgehäuse zur Aufnahme wenigstens einer vorzugsweise senkrecht zu einer Anreihrichtung ausgerichteten Leiterplatte mit einer Elektronik, die zu einer Seite hin mit einer Stift- oder Buchsenleiste versehen ist. Diese Stift- oder Buchsenleiste wird von einer Anschlussleiste kontaktiert, die an einer Seite zur Kontaktierung mit externen Leitern oder einer Steckerleiste ausgelegt ist.

DE 10 2009 059 011 A1 offenbart ein Verbindungssystem zum Verbinden eines einreihigen Gehäuses mit einem Anschlusselement. An dem einreihigen Gehäuse ist ein Anschlussbereich zum Verbinden des Anschlusselementes mit dem einreihigen Gehäuse vorgesehen. Das Anschlusselement ist mittels eines Steckkontaktes an dem Anschlussbereich befestigbar. Der Steckkontakt kann beispielsweise stiftförmig ausgebildet sein.

Aus DE 10 2009 035 716 A1 ist zudem ein Leiteranschlussteckverbinder mit einem Isolierstoffgehäuse und einer in dem Isolierstoffgehäuse aufgenommenen Klemmfeder bekannt. Das Isolierstoffgehäuse ist von einer Seite zur Aufnahme eines Stiftkontaktes und von der gegenüberliegenden Seite zur Aufnahme eines elektrischen Leiters vorgesehen, wobei der elektrische Leiter durch die Kraft der Klemmfeder gegen den Stiftkontakt gedrückt wird und diesen direkt oder durch ein zwischen liegendes Blechelement kontaktiert.

EP 1 513 385 A1 offenbart ein Elektronikgerätegehäuse mit zwei voneinander beabstandeten Seitenwandelementen zur Bildung eines Gehäuses mit einem Gehäuseinnenraum zur Aufnahme mindestens einer Leiterplatte. An mindestens einer der Stirnseiten ist im Zwischenraum zwischen den Seitenwandelementen mindestens ein Montageplatz für Leiteranschluss-Steckverbinder vorgesehen.

EP1 912 285 B1 offenbart ein elektrisches oder elektronisches Gerät mit einem Gehäuse, mit einer im Gehäuse angeordneten Leiterplatte und mit mindestens einem Steckverbinder, wobei in dem Gehäuse mindestens ein Steckanschluss zur Aufnahme des Steckverbinders angeordnet ist. Am Gehäuse ist im Bereich des Steckanschlusses ein Verriegelüngselement zur Verriegelung eines eingeseckten Steckverbinders schwenkbar gelagert. Neben der Funktion des Verriegelns des eingesteckten Steckverbinders erfüllt das Verriegelungselement gleichzeitig auch noch die Funktion einer Auswurfhilfe beim gewollten Lösen bzw. Herausziehen des Steckverbinders aus dem Steckanschluss.

Ausgehend hiervon ist es Aufgabe der vorliegenden Erfindung ein verbessertes Elektronikgerätegehäuse und ein Set von Zubehörteilen umfassend Auswerferelemente und Verriegelungselemente zu schaffen, das bei einem einfachen Aufbau eine flexible Anpassung im Bereich der Montageplätze für Leiterplatten-Steckverbinder erlaubt.

Die Aufgabe wird durch das Elektronikgerätegehäuse und das Set von Zubehörteilen umfassend Auswerferelemente und Verriegelungselemente mit den Merkmalen des Anspruchs 1 gelöst. Vorteilhafte Ausführungsformen sind in den Unteransprüchen beschrieben.

Es wird vorgeschlagen, dass das Elektronikgerätegehäuse im Bereich des mindestens einen Montageplatzes Aufnahmeeinrichtungen hat, die zur wahlweisen Aufnahme
- eines mittels der Aufnahmeeinrichtung verschwenkbar in einem Elektronikgerätegehäuse lagerbaren Auswerferelementes des vorgenannten Sets zum Auswerfen eines Leiteranschluss-Steckverbinders aus einem Montageplatz oder
- eines mittels der Aufnahmeeinrichtungen fest an einem Elektronikgerätegehäuse verrastbarem Verrieglungselement des vorgenannten Sets zum Verriegeln eines Leiteranschluss-Steckverbinders an einem Montageplatz, wobei mittels der Aufnahmeeinrichtungen ein Verschwenken des fest verrastet aufgenommenen Verriegelunaselementes sicher verhindert wird.
ausgebildet sind.

Gemäß der Lehre der vorliegenden Erfindung sind somit an den Montageplätzen Aufnahmeeinrichtungen vorgesehen, an denen wahlweise ein Auswerferelement oder ein Verriegelungselement angebracht werden können. Bei Auswahl eines Auswerferelementes ist der Leiteranschluss-Steckverbinder durch Verschwenkung des Auswerferelementes lösbar angeordnet, während bei Auswahl eines fest verrastet aufgenommenen Verriegelungselementes durch die verrastende Aufnahme der Leiteranschluss-Steckverbinder am Montageplatz verriegelt ist. Die Kontaktierung des Leiteranschluss-Steckverbinders ist davon unabhängig gleichbleibend.

Die Aufnahmeeinrichtungen an den Montageplätzen sind nun derart, dass wahlweise entweder eine verschwenkbare Lagerung eines Auswerferelementes oder eine fest verrastete Aufnahme eines Verriegelungselementes ermöglicht wird.

Damit ist es auf einfache Weise möglich, wahlweise einen Leiteranschluss-Steckverbinder auswerfbar oder fest verriegelt am Elektronikgerätegehäuse aufzunehmen, wobei nur ein Set von Zubehörteilen umfassend Auswerferelemente und Verriegelungselemente für ein Elektronikgerätegehäuse bereitgestellt werden muss.

Besonders vorteilhaft ist es, wenn die Aufnahmeeinrichtungen weiterhin zur wahlweisen Aufnahme eines mittels der Aufnahmeeinrichtungen fest an den Seitenwandelementen verrastbaren Blindkappenelementes zur Abdeckung eines freien, nicht zur Aufnahme eines Leiteranschluss-Steckverbinders vorgesehenen Montageplatzes vorgesehen sind. Damit kann das Set noch ein drittes Zubehörteil in Form eines Blindkappenelementes umfassen, das ebenso wie das Verriegelungselement fest am Elektronikgerätegehäuse verrastbar ist. Das Blindkappenelement kann somit dieselben Rasteinrichtungen haben, wie das Verriegelungselement und in derselben Weise wie das Verriegelungselement am Elektronikgehäuse verrastet werden. Im Unterschied zum Verriegelungselement, das den Leiteranschluss-Steckverbinder nur teilweise zur Verriegelung umgreift, wird mit dem Blindkappenelement der nicht genutzte Montageplatz abgedeckt.

Die Lagerung der Zubehörteile, an den Montageplätzen des Elektronikgerätegehäuses gelingt auf sehr einfache und zuverlässige Weise, wenn sich Zwischenwandabschnitte im Bereich der Montageplätze quer zu den Seitenwandelementen an einer jeweiligen Stirnseite erstrecken. Diese Zwischenwandabschnitte haben dann eine freie Oberkante mit einer Lagernut zur Aufnahme einer Lagerachse wahlweise eines Auswerferelementes, Verriegelungselementes oder Blindkappenelementes. Durch die sich quer zu den Seitenwandelementen erstreckenden Zwischenwandabschnitte wird somit ein stabiles Lager zur verschwenkbaren oder fest verrasteten Aufnahme eines Zubehörteils geschaffen, ohne dass die in der Regel dünneren und damit flexibleren Seitenwände übermäßig beansprucht werden.

Die Zwischenwandabschnitte können vorzugsweise ein integraler Teil eines Zwischenrahmens sein, der den Innenraum des Elektronikgerätegehäuses bildet und durch die Seitenwände seitlich abgeschlossen wird.

Besonders vorteilhaft ist es dabei, wenn an den Seitenwandelementen fluchtend mit der Lagernut Öffnungen zur Aufnahme von freien Enden einer Lagerachse vorgesehen sind. Die Lagerachse erstreckt sich damit auch durch die Seitenwandelemente, was die Stabilität der Lagerung erhöht. Insbesondere lässt sich das Zubehörteil in Form eines Auswerferelementes, Verriegelungselementes oder Blindkappenelementes dann nicht einfach von der Lagernut abziehen. Zur Entnahme des Zubehörteils müsste vielmehr die Lagerachse aus der Lagernut und in den Öffnungen der Seitenwandelemente herausgenommen werden.

Alternativ zu einer Lagernut an den Zwischenwandabschnitten können in dem unteren Bereich der Montageplätze an den Seitenwandelementen jeweils einander gegenüberliegende Paare von Öffnungen zur Aufnahme von freien Enden einer jeweils zugeordneten Lagerachse eines Auswerferelementes, Verriegelungselementes oder Blindkappenelementes vorgesehen sein. Bei dieser Variante wird das Zubehörteil an den Seitenwandelementen durch in die Öffnungen der Seitenwandelemente eingesteckte Lagerachsen gelagert. Diese Lagerachsen können z.B. seitlich vorstehende zylinderförmige Lagerbolzen sein. Mit Hilfe der Lageröffnungen in den Seitenwandelementen gelingt auch eine zuverlässige Lagerung ohne Verformung der Seitenwände nach außen. Die Lagerfläche ist dabei jedoch auf die in der Praxis recht kurzen Öffnungen reduziert, so dass die Kraft im Unterschied zu der zuvor beschriebenen Variante auf einen relativ kleinen Bereich der in der Praxis relativ dünnen Seitenwandelemente konzentriert wird.

Im oberen Bereich der Montageplätze können in einer bevorzugten Ausführungsform von den Seitenwandelementen Rastzapfen in den Zwischenraum zwischen den beiden Seitenwandelementen hineinragen. Die Rastzapfen sind dabei wahlweise zur Verrastung eines schwenkbaren Elektronikgerätegehäuses gelagerten Auswerferelementes vorgesehen, indem mindestens ein vom Seitenwandelement vorragender Rastzapfen in einer Rastöffnung am Auswerferelement eintaucht. Die vorstehenden Rastzapfen können aber auch zur Festlegung eines Verriegelungselementes oder Blindkappenelementes genutzt werden, indem eine umlaufend geschlossene Bohrung im Verriegelungselement oder Blindkappenelement vorgesehen ist, in die ein zugeordneter Rastzapfen eintaucht. Die seitlich von den Seitenwandelementen vorstehenden und einander gegenüberliegenden Rastzapfen können somit gleichermaßen zur Verrastung eines schwenkbaren Auswerferelementes und zur Fixierung eines Verriegelungselementes oder Blindkappenelementes genutzt werden. Für die lösbare Verrastung muss dann nur an dem Auswerferelement eine zum Rastzapfen korrespondierende Rastöffnung vorgesehen sein, während die feste Aufnahme des Verriegelungselementes oder Blindkappenelementes durch eine so weit umlaufende Bohrung bzw. Öffnung erreicht wird, dass der Rastzapfen nicht über der Rastöffnung seitlich aus der Bohrung bzw. Öffnung herausgeführt werden kann.

In Kombination mit den Rastzapfen oder bevorzugt alternativ zu den Rastzapfen an den Seitenwandelementen können im oberen Bereich der Montageplätze in den Seitenwandelementen Öffnungen zur Aufnahme seitlich von einem Auswerferelement vorstehenden Rastnasen oder seitlich von einem Verriegelungselement oder Blindkappenelement vorstehenden oder in diese über die Öffnungen in den Seitenwandelementen von außen fest einsteckbaren Verriegelungsstiften vorgesehen sein. Bei dieser Ausführungsform stehen somit Rastnasen oder Verriegelungsstifte von den Zubehörteilen (Auswerferelement, Verriegelungselement oder Blindkappenelement) hervor, die mit Öffnungen in den Seitenwandelementen zusammenwirken.

Die lösbare Verrastung eines schwenkbaren Auswerferelementes gelingt dadurch, dass eine Rastnase durch temporäre Verformung des Seitenwandelementes in eine zugeordnete Öffnung geführt wird. Die Rastnase kann hierzu z.B. eine geneigte Einführfläche haben, die das Ver- und Entriegeln zum Verschwenken des Auswerferelementes mit einer definierten Kraft erlaubt.

Die feste Verrastung, d.h. Fixierung der Verriegelungselemente oder Blindkappenelemente gelingt hingegen durch Verriegelungsstifte, die in die Öffnungen geführt werden und auch bei dem Versuch des Verschwenkens von Verriegelungselement oder Blindkappenelement nicht selbsttätig aus den Öffnungen herausgeführt werden können. Die Ausgestaltung der Rastnasen führt somit zur lösbaren Verriegelung während die Ausgestaltung der Verriegelungsstifte zur festen Verriegelung der Zubehörteile führt.

Diese Variante ist relativ einfach und preiswert, hat jedoch den Nachteil, dass die Seitenwände bei Verschwenken des Auswerferelementes temporär verformt werden.

Im unteren Bereich des Elektronikgerätegehäuses ist vorzugsweise eine Bodenplatte mit einem Tragschienenrastfuß zum Aufrasten des Elektronikgerätegehäuses auf einer Tragschiene vorgesehen. Diese Bodenplatte kann bspw. integraler Teil eines Zwischenrahmens sein, der seitlich von den Seitenwandelementen abgedeckt wird und den Innenraum des Elektronikgerätegehäuses bildet.

Durch einen solchen Tragschienenrastfuß wird ein Elektronikgerätegehäuse geschaffen, das ohne großen Montageaufwand auf eine Tragschiene aufgerastet werden und nebeneinander in den weiteren Elektronikgerätegehäusen und/oder Reihenklemmen oder sonstigen elektrischen Geräten aufgereiht werden kann.

Im oberen Bereich des Elektronikgerätegehäuses ist in einer bevorzugten Ausführungsform mindestens eine gekrümmte Verriegelungszapfen-Aufnahmeöffnung zur Aufnahme jeweils eines zugeordneten Verriegelungszapfens vorgesehen, der von einem Deckelelement abragt. Mit Hilfe einer solchen Aufnahmeöffnung für einen gekrümmten Verriegelungszapfen gelingt es, ein Deckelelement manipulationssicher am Elektronikgerätegehäuse zu lagern. Die Verriegelungszapfen in der Aufnahmeöffnung bilden beim Heraushebeln des Deckelelementes nach oben vom Elektronikgerätegehäuse weg einen Anschlag, der ein unbefugtes Entfernen des Deckelelementes verhindert. Zudem kann eine solche Aufnahmeöffnung für einen Verriegelungszapfen auch als Lagerung für ein Deckelelement und als ein auf das Elektronikgerätegehäuse aufsetzbares Displayelement genutzt werden.

Besonders vorteilhaft ist es, wenn im unteren Bereich von Montageplätzen wahlweise Kontaktträger mit Kontaktstiften einbringbar sind. Dabei sind die Kontaktstifte mit einem freien Ende zur Kontaktierung mit einer in den Innenraum des Elektronikgerätegehäuses einbringbaren Leiterplatte und mit dem jeweils anderen freien Ende als Gegenkontakt für einen in den Montageplatz einsteckbaren Leiterplatten-Steckverbinder ausgerichtet. Ein solcher Kontaktträger mit Kontaktstiften kann an den Montageplätzen bedarfsweise eingebracht werden, an denen Leiterplatten-Steckverbinder einsteckbar sein sollen. Die Übrigen, nicht mit einem Kontaktträger versehenen Montageplätze können dann durch ein Blindkappenelement abgedeckt werden. Ein solcher Kontaktträger mit Kontaktstiften hat den Vorteil, dass die Kontaktstifte im Kontaktträger fest gelagert sind und mit dem Kontaktträger eine Einheit bilden. Ein solcher Kontaktträger unterstützt den modularen Aufbau des Elektronikgerätegehäuses, das dann je nach Bedarf mit Hilfe der Zubehörteile an den Montageplätzen mit Kontaktträgern und lösbaren oder fest verriegelten Leiterplatten-Steckverbindern oder mit Blindkappenelementen bestückt werden kann.

Der Kontaktträger kann auch als Lager für das Zubehörteil (Auswerferelement, Verriegelungselement oder Blindkappenelement) benutzt werden.

Das Auswerferelement ist bevorzugt so ausgebildet, dass das Auswerferelement benachbart zu einer Lagerachse mindestens einen vorstehenden Finger hat. Der mindestens eine Finger untergreift dann im schwenkbar an den Aufnahmeeinrichtungen des Elektronikgerätegehäuses eingebauten Zustand einen in einen zugeordneten Montageplatz eingesteckten Leiterplatten-Steckverbinder, um diesen durch Verschwenken des Auswerferelementes aus dem Montageplatz auszuwerfen. Das Auswerferelement ist somit im Querschnitt L-förmig ausgeführt, wobei die Lagerachse im Übergang vom Finger zum abgehenden Betätigungsarm angeordnet ist.

Das Verriegelungselement ist bevorzugt so ausgeführt, dass an einer freien Oberkante mindestens ein vorstehender Kragen vorgesehen ist. Der Kragen ist dann so angepasst, dass in der an einen Montageplatz am Elektronikgerätegehäuse verrasteten Position einen in diesen Montageplatz eingesteckter Leiterplatten-Steckverbinder von dem Kragen übergriffen und vor Entnahme aus dem Montageplatz gesichert wird.

Die Verriegelung des Leiterplatten-Steckverbinders in der Steckposition gelingt somit dadurch, dass das Verriegelungselement mit Hilfe des Kragens den Leiterplatten-Steckverbinder übergreift und damit vor Herausziehen sichert.

Die Erfindung wird nachfolgend anhand eines Ausführungsbeispiels mit den beigefügten Zeichnungen näher erläutert. Es zeigen:
- Figur 1 -: perspektivische Ansicht eines Elektronikgerätegehäuses mit einem noch nicht vollständig eingesteckten Leiteranschluss-Steckverbinder;
- Figur 2 -: perspektivische Explosionsansicht des Elektronikgerätegehäuses aus Figur 1;
- Figur 3 -: perspektivische Explosionsansicht des Elektronikgerätegehäuses aus Figur 2 mit noch nicht an Montageplätzen positionierten Leiteranschluss-Steckverbindern und zugehörigen Kontaktträgern;
- Figur 4 -: Ausschnittsansicht eines Elektronikgerätegehäuses mit abgenommener Seitenwand im Bereich eines Auswerferelementes mit eingesetztem Leiteranschluss-Steckverbinder in Steck- und Verriegelungsposition;
- Figur 5 -: Ausschnittsansicht gemäß Figur 4 mit verschwenktem Auswerferelement und Leiteranschluss-Steckverbinder in Entnahmeposition;
- Figur 6 -: perspektivische Ansicht des Auswerferelementes;
- Figur 7 -: perspektivische Ansicht des Auswerferelementes mit aufgesteckten Beschriftungselementen;
- Figur 8 -: Ausschnittsansicht eines am Elektronikgerätegehäuse gelagerten Auswerferelementes im Bereich der Lagerachse in Steckposition;
- Figur 9 -: Ausschnittsansicht aus Figur 9 mit Auswerferelement in Entnahmestellung;
- Figur 10 -: Ausschnittsansicht einer in weiterer Ausführungsform eines Auswerferelementes in Steckposition mit Vorsprung an der Lagerachse;
- Figur 11 -: Ausschnittsansicht gemäß Figur 10 in Entriegelungsposition;
- Figur 12 -: perspektivische Ansicht eines Kontaktträgers zum Einbau in einem Montageplatz;
- Figur 13 -: perspektivische Ansicht einer weiteren beispielhaften Zusammenstellung des Elektronikgerätegehäuses;
- Figur 14 -: Ausschnittsansicht auf ein Elektronikgerätegehäuse im Bereich eines Leiteranschluss-Steckverbinders mit Auswerfereinheit in Steckposition mit Beschriftungselementen;
- Figur 15 -: Ausschnittsansicht auf ein Elektronikgerätegehäuse im Bereich eines Leiteranschluss-Steckverbinders mit Verriegelungselement in Steckposition mit Beschriftungselementen;
- Figur 16 -: Ausschnittsansicht eines Elektronikgerätegehäuses mit abgenommener Seitenwand im Bereich eines Deckelelementes mit Verriegelungszapfen;
- Figur 17 -: Ausschnittsansicht des Elektronikgerätegehäuses nach Figur 16 im Bereich des vorderen Endes des Deckelelementes.

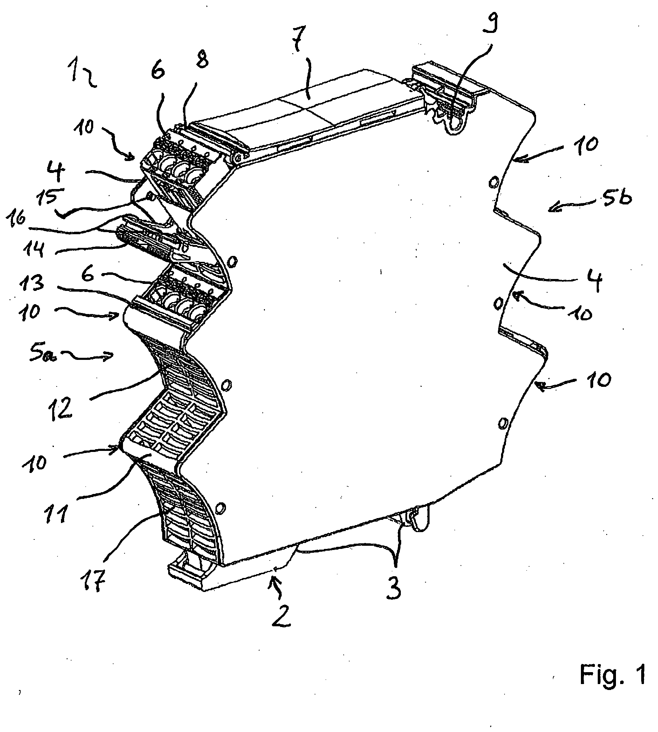

Figur 1 lässt eine perspektivische Ansicht eines Elektronikgerätegehäuses 1 erkennen, das einen nicht sichtbaren Zwischenrahmen zur Bildung eines Innenraums zur Aufnahme von Elektronik z.B. auf einer Leiterplatte hat. Der Zwischenrahmen hat im unteren Bereich eine Bodenplatte 2 mit einem Tragschienenrastfuß 3, der ein lösbares Aufrasten des Elektronikgerätegehäuses auf einer Tragschiene erlaubt. Auf diese Weise sind mehrere solche Elektronikgerätegehäuse 1 nebeneinander auf der Tragschiene anreihbar.

Das Elektronikgerätegehäuse 1 ist an den Seiten mit Hilfe von Seitenwänden 4 abgeschlossen. Die voneinander beabstandeten Seitenwände bilden einen Zwischenraum an der vorderen Stirnseite 5a und hinteren Stirnseite 5b zur Aufnahme von Leiteranschluss-Steckverbindern 6. Auf diese Weise kann das Elektronikgerätegehäuse 1 über die Leiteranschluss-Steckverbinder 6 mit elektrischen Leitungen verbunden werden.

Die Oberseite des Elektronikgerätegehäuses 1 ist durch einen verschwenkbaren Deckel 7 abgedeckt, der an einem Schwenklager 8 gelagert ist. Weiterhin ist an der Oberseite des Elektronikgerätegehäuses 1 eine Rastnut 9 zur Aufnahme von Kennzeichnungselementen oder ähnliches vorgesehen.

An der vorderen und hinteren Stirnseite 5a, 5b sind auf drei Ebenen jeweils Montageplätze vorgesehen, die zur Montage von Leiteranschluss-Steckverbindern 6 genutzt werden können. Das Elektronikgerätegehäuse 1 kann jedoch individuell vom Nutzer so zusammengestellt werden, dass gegebenenfalls Montageplätze frei bleiben und nicht mit Leiteranschluss-Steckverbindern 6 bestückbar sind.

Für den Fall, dass ein Montageplatz 10 frei bleibt und nicht mit einem Leiteranschluss-Steckverbinder 6 bestückbar sein soll, kann dieser Montageplatz an der jeweiligen Stirnseite 5a, 5b mit einem Blindkappenelement 11 abgedeckt werden. Dieses Blindkappenelement 11 wird an dem Elektronikgehäuse 1 fest verrastet und ist bei zusammengebautem Elektronikgerätegehäuse 1 mit aufgesetzten Seitenwänden 4 nicht ohne Weiteres herausnehmbar.

Für den Fall, dass ein Montageplatz 10 mit einem Leiteranschluss-Steckverbinder 6 bestückbar ist, hat der Nutzer zwei Optionen.

Einerseits ist es möglich einen Leiteranschluss-Steckverbinder 6 fest in einem Montageplatz 10 einzubauen. Hierzu dient ein fest an dem Elektronikgerätegehäuse 1 verrastbares Verriegelungselement 12. Dieses wird vergleichbar zum Blindkappenelement 11 mit dem Elektronikgerätegehäuse 1 zusammengesteckt und ist dann nicht einfach lösbar, sondern positionsfest am Elektronikgerätegehäuse 1 gelagert. Dabei hat das Verriegelungselement 12 an der Oberseite einen vorstehenden Kragen 13, der so angepasst ist, dass das Verriegelungselement 12 in der in Figur 1 dargestellten, an einem Montageplatz 10 am Elektronikgerätegehäuse 1 verrasteten Position einen an diesem Montageplatz 10 vollständig eingesteckten Leiteranschluss-Steckverbinder 6 von dem Kragen 13 übergriffen und gegen eine Entnahme aus dem Montageplatz 10 gesichert wird. Alternativ oder zusätzlich zu dem Kragen 13 können auch Rastöffnungen vorgesehen sein, in diesen vorstehende Rastzapfen eines Leiteranschluss-Steckverbinders 6 eintauchen, um diesen zu verriegeln. Deutlich wird, dass der Leiteranschluss-Steckverbinder 6 nicht z.B. bei Zug auf einen in den Leiteranschluss-Steckverbinder 6 eingesteckten elektrischen Leiter nach oben aus dem Elektronikgerätegehäuse 1 abgezogen werden kann. Dies wird durch den Kragen 13 verhindert, der den Leiteranschluss-Steckverbinder 6 übergreift.

Auf diese Weise kann mit dem Verriegelungselement 12 bewirkt werden, dass ein zugeordneter Leiteranschluss-Steckverbinder 6 ebenfalls fest in dem Elektronikgerätegehäuse 1 eingebaut ist. Dies ist insbesondere für Anwendungen vorteilhaft, bei denen ein Berührschutz aufgrund gefährlicher Spannungen notwendig ist.

In der Praxis besteht jedoch oftmals der Bedarf, dass elektrische Leiter z.B. beim Auswechseln eines defekten Elektronikgerätes mit einem Leiteranschluss-Steckverbinder 6 verbunden bleiben sollen und der Leiteranschluss-Steckverbinder 6 bei Austausch einfach in das neue Elektronikgerätegehäuse 1 eingesteckt werden soll. Hierzu ist es vorteilhaft, wenn die Leiteranschluss-Steckverbinder 6 auf einfache Weise lösbar mit dem Elektronikgerätegehäuse 1 verbindbar sind. Hierzu ist die Bereitstellung von Auswerferelementen 14 vorgesehen, die verschwenkbar an dem Elektronikgerätegehäuse 1 angeordnet werden können. Diese Anordnung ist insofern vorteilhaft, weil sowohl bei Verwendung eines Verriegelungselementes 12, als auch eines Auswerferelementes 14 ein baugleicher Leiteranschluss-Steckverbinder 6 verwendet werden kann.

Erkennbar ist aus Figur 1, dass das Auswerferelement 14 am Montageplatz 10 oben links an der vorderen Stirnseite 5a in die Entnahmestellung verschwenkt, d.h. geöffnet, ist. Dabei wird der Leiteranschluss-Steckverbinder 6 teilweise aus dem Elektronikgerätegehäuse 1 herausgeführt.

An den Seitenwänden 4 sind in dem Zwischenraum an der jeweiligen Stirnseite 5a, 5b jeweils hineinragende und auf die gegenüberliegende Seitenwand zuweisende Rastzapfen 15 vorgesehen. Diese Rastzapfen 15 sind an den Montageplätzen 10 benachbart zur gegebenenfalls eingesteckten Leiteranschluss-Steckverbindern 6 angeordnet und auf Rastöffnungen 16 in den Auswerferelementen 14 ausgerichtet. Beim Verschwenken des Auswerferelementes 14 in Richtung Leiteranschluss-Steckverbinder 6 werden die Rastöffnungen 16 an den Innenseiten der Auswerferelemente 14 in zugeordnete Rastzapfen 15 geführt. Damit verrastet das Auswerferelement 14 in der geschlossenen Steckposition an den Rastzapfen 15 und den Seitenwänden 4 des Elektronikgerätegehäuses 1. Der Leiteranschluss-Steckverbinder 6 ist dabei vollständig in den Montageplatz 10 eingesteckt. Durch das verrastete Auswerferelement 14 wird der Leiteranschluss-Steckverbinder 6 in dieser Steckposition gehalten. Die Sicherung des Leiteranschluss-Steckverbinders 6 an dem Elektronikgerätegehäuse 1 in der Steckposition kann verbessert werden, wenn der Leiteranschluss-Steckverbinder 6 mit dem verrasteten Auswerferelement 14 zusammenwirkt, z.B. durch einen das Herausziehen des Leiteranschluss-Steckverbinders 6 nach oben verhindernden Anschlag zwischen Leiteranschluss-Steckverbinder 6 und Auswerferelement 14.

Unter Umständen ist es für ein Elektronikgerät wichtig, eine Luftzirkulation im Elektronikgerätegehäuse 1 zur Kühlung bereitzustellen. Für diesen Zweck ist es vorteilhaft, wenn zumindest die Blindkappenelemente 11 Lüftungsschlitze 17 haben. Denkbar ist, dass auch die Verriegelungselemente 12 und/oder Auswerferelemente 14 Lüftungsschlitze haben oder zumindest im Bereich unterhalb des Auswerferelementes 14 und Verriegelungselementes 12 solche Lüftungsschlitze im Zwischenrahmen vorgesehen sind.

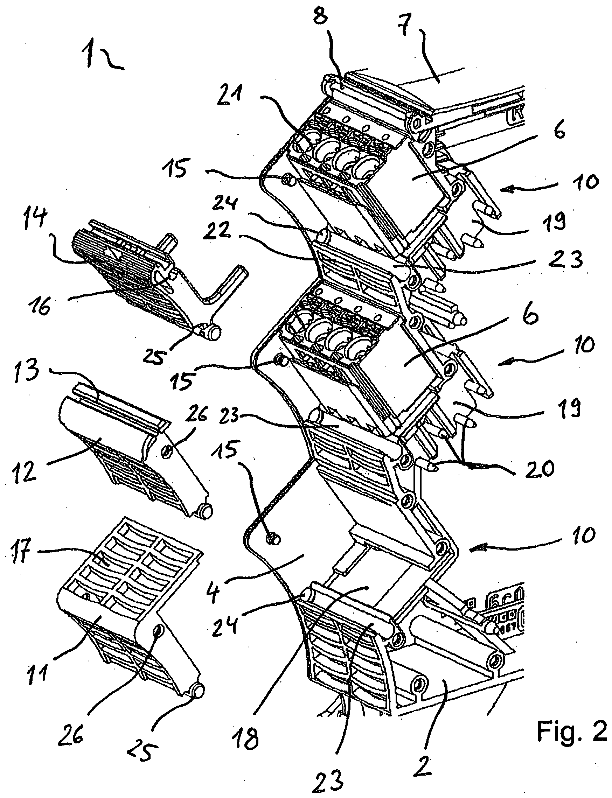

Figur 2 lässt eine perspektivische Explosionsansicht eines Ausschnitts des Elektronikgerätegehäuses 1 aus Figur 1 erkennen. Dabei wird deutlich, dass sich im Innenraum des Elektronikgerätegehäuses 1 entlang der Stirnseiten 5a und entsprechend der gegenüberliegenden Stirnseite 5b (nicht sichtbar) ein Zwischenrahmen 18 erstreckt, an dem auf drei Ebenen Montageplätze 10 vorgesehen sind. Der Zwischenrahmen 18 wird beidseits durch Seitenwände 4 abgeschlossen, wobei in Figur 2 nur der linke Seitenrahmen sichtbar ist. Optional kann der Zwischenrahmen 18 und eine Seitenwand 4 einstückig geformt sein.

An den Montageplätzen 10 sind wahlweise Kontaktträger 19 einsetzbar. Diese Kontaktträger 19 haben Kontaktstifte 20, die einerseits zur Verbindung mit einer Leiterplatte im Elektronikgerätegehäuse 1 und andererseits zur elektrischen Kontaktierung eines Leiteranschluss-Steckverbinders 6 vorgesehen sind. Deutlich wird, dass in diesem Ausführungsbeispiel jeder Kontaktträger 19 vier Kontaktstifte 20 hat. Damit kann jeweils einer der vier Leiteranschlüsse der Leiteranschluss-Steckverbinder 6 mit einem zugeordneten Kontaktstift 20 verbunden werden. Die Kontaktträger 19 eignen sich insbesondere zur Verbindung mit einem Leiteranschluss-Steckverbinder 6 der in der DE 10 2007 018 443 A1 und DE 10 2009 035 716 A1 beschriebenen Art, auf die vollumfänglich Bezug genommen wird. Die Leiteranschluss-Steckverbinder 6 haben hierbei im Isolierstoffgehäuse eingebaute Klemmfedern (z.B. U-förmige Klemmfedern), die einen in eine Leitereinführungsöffnung 21 des Leiteranschluss-Steckverbinders 6 eingeführten elektrischen Leiter in Richtung eines neben den elektrischen Leiter in den Leiteranschluss-Steckverbinder 6 eintauchenden Kontaktstift 20 drücken. Auf diese Weise wird der elektrische Leiter direkt oder über ein zwischen liegendes Blech kontaktiert. Der Leiteranschluss-Steckverbinder 6 ist so ausgebildet, dass ein elektrischer Leiter vorher bereits in eine zugeordnete Leiteranschlussöffnung 21 eingesteckt werden kann, ohne dass die Einstecköffnung für den zugeordneten Kontaktstift 20 durch den elektrischen Leiter verschlossen wird.

Die Kontaktträger 19 sind bei der Bestückung des Elektronikgerätegehäuses durch den Nutzer wahlweise in einen Montageplatz 10 einsteckbar.

Der in Figur 2 dargestellte untere Montageplatz 10 ist nicht mit einem Kontaktträger 19 bestückt, sondern soll frei bleiben. Um diesen unbestückten Montageplatz abzudecken ist ein Blindkappenelement 11 vorgesehen, das im Querschnitt L-förmig ist. Auf diese Weise wird die Stirnseite des Montageplatzes 10 jeweils vorne und oben abgedeckt.

Das Elektronikgerätegehäuse 1 hat an den Montageplätzen 10 sich quer zu den Seitenwandelementen 4 an eine jeweilige Stirnseite 5a, 5b erstreckende Zwischenwandabschnitte 22 mit einer Lagernut 23 an der freien Oberkante. Fluchtend mit dieser Lagernut 23 können die Seitenwände 4 Öffnungen 24 zur Aufnahme von freien Enden an der Lagerachse 25 haben.

Auf diese Weise lassen sich die Zubehörteile umfassend Auswerferelemente 14, Verriegelungselemente 12 und Blindkappenelemente 11 prinzipiell schwenkbar am Elektronikgerätegehäuse 1 lagern. Hierzu haben die Zubehörteile (Auswerferelement 14, Verriegelungselement 12 und Blindkappenelement 11) an ihrer Unterkante jeweils eine Lagerachse 25, die in eine zugeordnete Lagernut 23 eingesetzt werden kann. Deutlich wird, dass die Lagerachsen 25 der Zubehörteile länger als die Breite der Zubehörteile sind und damit überstehen, so dass die freien Enden in die Öffnungen 24 der Seitenwände 4 eintauchen.

Die Lagernuten 23 sind vorzugsweise teilkreisförmig so ausgestaltet, dass die Lagerachsen 25 in die Lagernuten 23 eingeclipst und dort gehalten werden. Die Lagernuten 23 übergreifen damit die Lagerachsen 25 in einem Umfang von mehr als 180°.

Erkennbar ist weiterhin, dass von den Seitenwänden 4 Rastzapfen 15 vorspringen. Das Auswerferelement 14 ist nunmehr verschwenkbar an einem Montageplatz 10 gelagert, indem es im oberen Bereich nicht fest mit den Seitenwänden oder dem Elektronikgehäuse verbunden ist. Vielmehr ist die einseitig offene Rastöffnung 16 so ausgestaltet, dass der Rastzapfen 15 in die zugeordnete Rastöffnung 16 eingeclipst werden kann. Durch Ausüben einer ausreichenden Kraft wird die Verrastung zwischen Rastöffnung 26 und Rastzapfen 15 gelöst und das Auswerferelement 14 um die Lagerachse 25 in der Lagernut 23 verschwenkt. Dabei wird die Verriegelung gelöst und der zugeordnete Leiteranschluss-Steckverbinder 6 aus dem Montageplatz 10 herausgeführt.

Die Rastzapfen 15 können gleichermaßen aber auch zur festen Verrastung von Zubehörteilen in einem Elektronikgerätegehäuse 1 genutzt werden. Hierzu sind an dem Verriegelungselement 12 und dem Blindkappenelement 11 jeweils seitlich ringsum geschlossene Bohrungen 26 vorgesehen. Wenn das Verriegelungselement 12 oder Blindkappenelement 11 fest an einem Montageplatz 10 eingebaut ist, taucht ein zugeordneter Rastzapfen 15 in die zugeordnete Bohrung 26 ein. Hierdurch wird ein Verschwenken des Verriegelungselementes 12 bzw. Blindkappenelementes 11 sicher verhindert. Das Verriegelungselement 12 bzw. Blindkappenelement 11 wird auf diese Weise an der Position gehalten.

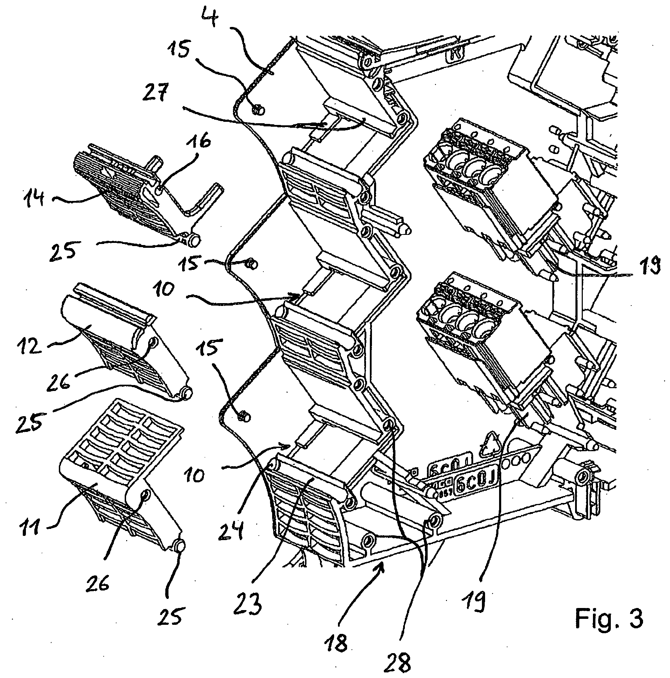

Figur 3 lässt eine perspektivische Explosionsansicht erkennen, bei der die Kontaktträger 19 noch nicht in einem zugeordneten Montageplatz 10 eingesetzt sind. Deutlich wird, dass die Montageplätze 10 Führungen bzw. Rastvorsprünge 27 haben, an denen die zugeordneten Kontaktträger 19 einen Zwischenrahmen 18 festlegbar sind. Die Kontaktträger 19 können somit von der Seite in einen Montageplatz 18 eingeschoben und dort mit Hilfe der Führungselemente 27 in die Montageposition geführt und dort festgelegt werden.

Erkennbar ist weiterhin, dass der Zwischenrahmen eine Vielzahl von Rastöffnungen 28 zur Aufnahme korrespondierender Raststifte der Seitenwände 4 hat, um die Seitenwände auf den Zwischenrahmen 18 aufzustecken und mit diesem zu verrasten.

Damit ist lässt sich ein Elektronikgerätegehäuse 1 modular vom Anwender je nach Bedarf zusammenstellen.

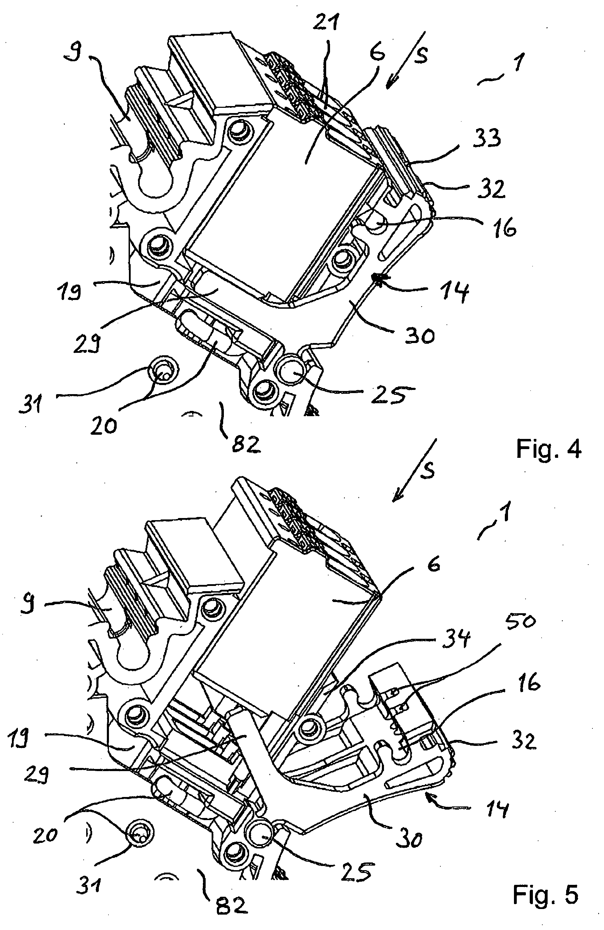

Figur 4 lässt eine Ausschnittsansicht des Elektronikgerätegehäuses 1 im Bereich eines Auswerferelementes 14 erkennen. Deutlich wird, dass das Auswerferelement 14 im Querschnitt L-förmig ausgebildet ist. Benachbart zu der Lagerachse 25 ist in dem dargestellten Ausführungsbeispiel ein Paar vorstehender Finger 29 vorgesehen, die voneinander beabstandet an jeder Seite angeordnet sind. Von der Lagerachse geht im Winkel, bevorzugt etwa senkrecht (70°-120°) ein Betätigungsarm 30 nach oben ab, der sich annähernd parallel zu dem eingesteckten Leiteranschluss-Steckverbinder 6 erstreckt.

Deutlich wird, das in der dargestellten Steckposition, bei der der Leiteranschluss-Steckverbinder vollständig auf dem zugeordneten Kontaktträger 19 aufgesteckt ist, die Finger 29 unterhalb des Leiteranschluss-Steckverbinders 6 positioniert sind. Die Finger 29 erstrecken sich dann quer zur Steckrichtung S des Leiteranschluss-Steckverbinders.

Erkennbar ist weiterhin, dass die freien Enden der Kontaktstifte 20 durch Lötbohrungen 31 einer Leiterplatte 82 geführt sind, um mit der Leiterplatte 82 verlötet zu werden.

Deutlich wird weiterhin, dass die Auswerferelemente 14 im oberen Bereich eine geriffelte Grifffläche 32 und eine Betätigungsöffnung 33 haben. Die geriffelte Grifffläche 32 erleichtert das Verschwenken des Aufwerferelementes 14 von Hand. Die Betätigungsöffnung 33 kann dann zum Einführen eines Schraubendrehers genutzt werden, der als Hebel zum Verschwenken des Auswerferelementes 14 dient.

Figur 5 lässt die Ausschnittsansicht aus Figur 4 in der verschwenkten Entnahmeposition erkennen. Deutlich wird, dass der Leiteranschluss-Steckverbinder mit Hilfe des mit seinem freien Ende nach oben verschwenkten Fingers 29 vom Kontaktträger 19 weg geführt wird. Mit Hilfe der Verschwenkung des Auswerferelementes 14 und der Finger 29 gelingt es, den Leiteranschluss-Steckverbinder 6 definiert nach oben von den Kontaktstiften abzuziehen. Eine Führung des Leiteranschluss-Steckverbinders 6 in Steckrichtung bzw. entgegengesetzt hierzu wird zudem durch eine seitliche Führungswand 34 am Kontaktträger 19 sichergestellt. Diese Führungswand 34 befindet sich in der Schließposition gemäß Figur 4 zwischen dem Auswerferelemente 14 und dem Leiteranschluss-Steckverbinder 6.

An dem Auswerferelement 14 können Rastelemente zur Verrastung des Leiteranschluss-Steckverbinders 6 in der Schließposition beispielsweise in Form von Rastöffnungen 50, in die vom Leiteranschluss-Steckverbinder 6 vorstehende Rastzapfen eintauchen, vorgesehen sein.

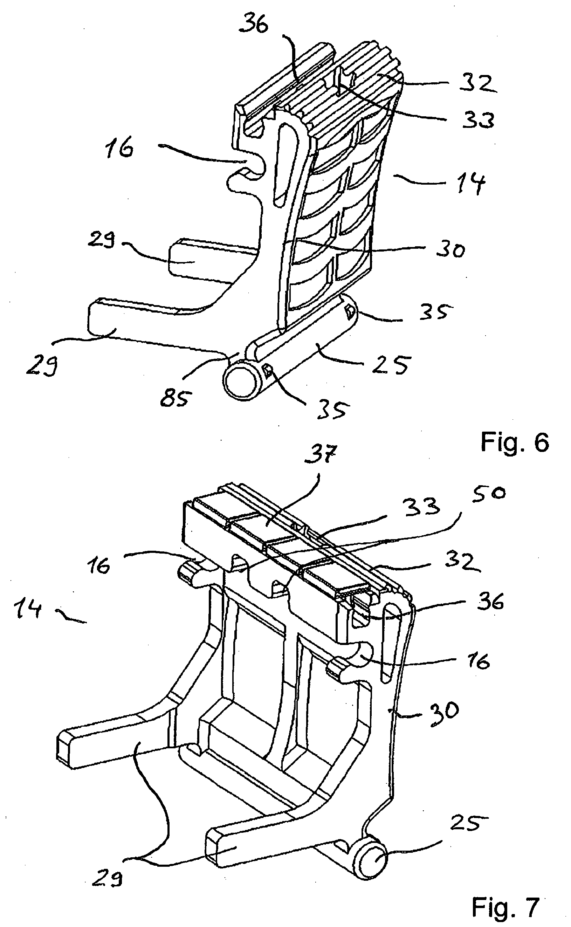

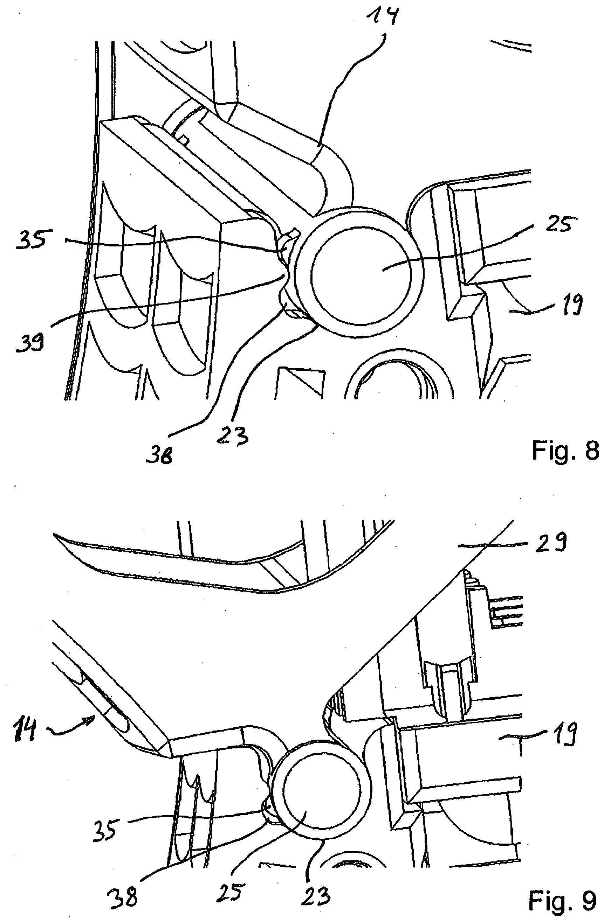

Figur 6 lässt eine perspektivische Ansicht eines Auswerferelementes 14 erkennen. Deutlich wird, dass zwei Finger 29 voneinander beabstandet an den beiden Seiten des Auswerferelementes 14 angeordnet sind. Die Finger 29 erstrecken sich mit ihrem freien Ende parallel zueinander und gehen gegenüberliegend zum freien Ende in einen quer hiervon abragenden Betätigungsarm 30 über. Im Übergang von Finger 29 und Betätigungsarm 30 ist unterhalb davon die Lagerachse 25 an einem Steg 85 als Übergang zum Finger 29 und Betätigungsarm 30 angeordnet. Erkennbar ist, dass an der Lagerachse 25 jeweils an den beiden äußeren Bereichen vorstehende Rastnasen 35 vorgesehen sind. Diese Rastnasen tauchen in der in den Figuren 5 und 9 gezeigten Offenstellung in korrespondierende Mulden 38 in der Lagernut 23 ein. Damit wird erreicht, dass das Auswerferelement 14 in einer definierten Offenstellung gehalten wird. In der Schließstellung gemäß Figur 4 und Figur 8 verrasten die Nasen 35 an einem darunter liegenden Vorsprung 39 der Lagernut 23 angrenzend an die Mulde 38, um das Auswerferelement 14 in der definierten Schließposition zu verrasten. Zum Verschwenken des Auswerferelementes 14 muss daher eine gewisse Kraft aufgebracht werden, um den an den Nasen 35 wirkenden Anschlag zu überwinden.

Weiterhin wird aus Figur 6 deutlich, dass an der Oberseite des Auswerferelementes 14 eine Rastnut 36 zur Aufnahme von Beschriftungselementen eingebracht ist. Diese Beschriftungselemente können dann in die Rastnut 36 eingeclipst und dort gehalten werden.

Figur 7 lässt eine perspektivische Ansicht des Auswerferelementes 14 gemäß Figur 6 von der anderen Seite (Rückseite) erkennen. Dabei wird deutlich, dass nunmehr in die Rastnut 36 Beschriftungselemente 37 eingeclipst sind. Es sind vier einzelne oder über eine Sollbruchstelle miteinander verbundene Beschriftungselemente 37 vorgesehen, wobei für jede Leitereinführungsöffnung des 4-poligen Leiteranschluss-Steckverbinders 6 ein Beschriftungselement 37 vorgesehen ist.

Figur 8 lässt eine Ausschnittsansicht des in einer Lagernut 23 mit der Lagerachse 25 eingesetzten Auswerferelementes 14 in der Schließstellung gemäß Figur 4 erkennen. Deutlich wird, dass die vorstehende Nase 35 an der Lagerachse 25 zusammen mit einem die Mulde 38 in der Lagernut 23 begrenzenden Vorsprung 39 einen Anschlag bildet, der das Auswerferelement 14 in der Schließposition hält. Zum Verschwenken des Auswerferelementes 14 in der Darstellung entgegen des Uhrzeigersinns muss dieser Anschlag überwunden werden. Hierzu ist eine gewisse Kraft bzw. ein ausreichendes Drehmoment erforderlich.

Wenn das Auswerferelement dann in die Offenlage gemäß Figur 5 und 9 verschwenkt ist, taucht die vorstehende Nase 35 der Lagerachse 25 in die Mulde 38 der Lagernut 23 ein. Damit ruht das Auswerferelement 14 in dieser definierten Offenstellung.

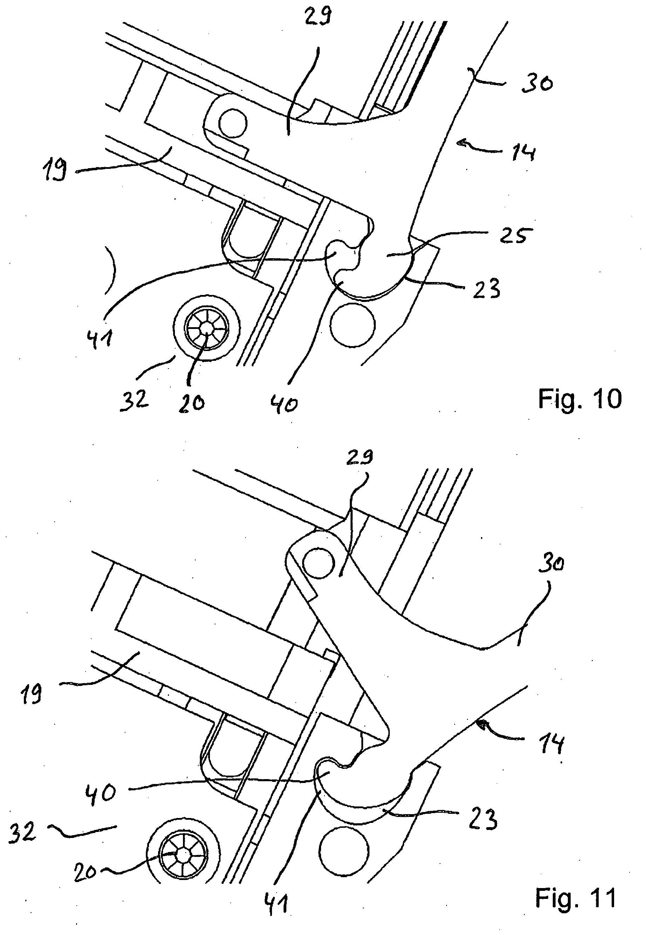

Figur 10 lässt eine Ausschnittsansicht einer weiteren Ausführungsform eines Auswerferelementes 14 erkennen. Dieses Auswerferelement 14 ist wiederum L-förmig mit mindestens einem Finger 29 und einem quer nach oben abragendem Betätigungsarm 30 und unten liegender Lagerachse 25 ausgeführt. Die Lagerachse 25 ist wiederum vorgewölbt und in die Rastnut 23 eingeschnappt bzw. eingeclipst. Sie ist im Querschnitt teilkreisförmig und vergleichbar mit dem Rundstab der vorher beschriebenen Lagerachse 25 mit dem Unterschied, dass eine Nase 40 von der Lagerachse 25 abragt. Die Lagernut 23 hat eine an die Nase 40 angepasst Vertiefung 41 bzw. Mulde, in die die Nase 40 im zurückgeschwenkten Zustand der Auswerfereinheit 14 eintauchen kann. Dies ist in der Figur 11 skizziert, die die Auswerfereinheit 14 in der Offenstellung entsprechend Figur 5 zeigt.

Auf diese Weise bildet die Nase 40 und die Begrenzungswand der Vertiefung 41 einen Anschlag, mit dem ein unerwünschtes Heraushebeln der Auswerfereinheit 14 verhindert oder zumindest erschwert wird. Ein weiteres Verschwenken der Auswerfereinheit 14 über die in Figur 11 dargestellte Offenlage ist aufgrund der Nase 41 nicht möglich.

Die Nase 40 und die korrespondierende Vertiefung 41 können sich über die gesamte Breite der Lagerachse 25 und/oder Lagernut 23 erstrecken. Denkbar ist aber auch, dass wie bei den Nasen 35 des vorhergehenden Ausführungsbeispiels (siehe Figur 6) nur eine beschränkte Anzahl von 1, 2, 3, 4 oder mehr Nasen 40 vorgesehen sind, die im Abstand voneinander angeordnet sind. In diesem Zusammenhang ist denkbar, dass die Vertiefung 41 bzw. Mulde sich über die gesamte Länge der Lagernut 23 erstreckt oder auch nur angepasst an die einzelnen Nasen 40 einzelne Vertiefungen 41 in die Lagernut 23 eingebracht sind.

Die Nasen 40 sind integral mit der Lagerachse 25 vorzugsweise aus einem Kunststoffmaterial geformt.

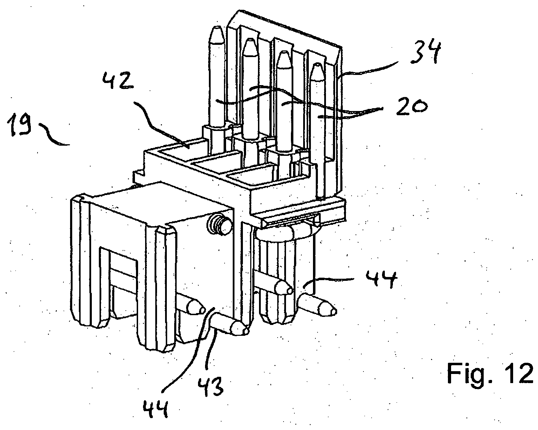

Figur 12 lässt eine perspektivische Ansicht eines Kontaktträgers 19 erkennen, der aus einem Isolierstoffmaterial (insbesondere Kunststoff) geformt ist. Der Kontaktträger 19 hat darin fest eingebaute Kontaktstifte 20, die in z.B. einer Reihe nebeneinander angeordnet sind und sich parallel zueinander in Steckrichtung erstrecken. Die Kontaktstifte 20 haben somit jeweils einen geradlinigen Kontaktabschnitt, der von einer Plattform 42 des Kontaktträgers 19 mit seinem freien Ende nach oben abragt. Deutlich wird, dass der geradlinige Kontaktabschnitt vom Isolierstoffmaterial des Kontaktträgers 19 umgeben und in diesem Fixierbereich an dem Kontaktträger 19 festgelegt ist. Die Kontaktstifte 20 werden an der Plattform im Fixierbereich stabil gehalten, indem diese von dem Isolierstoffmaterial um einen Umfang von mehr als 180° und bevorzugt mehr als 270° oder vollständig (360°) vom Isolierstoffmaterial umschlossen sind.

Deutlich wird weiterhin, dass die Kontaktstifte 20 unterhalb der Plattform 42 abgewinkelt sind, so dass seitlich aus dem Kontaktträger 19 zur Anbindung an eine Leiterplatte 82 freie Enden der Kontaktstifte 20 aus dem Kontaktträger 19 herausragen. Die Erstreckungsrichtung dieser freien Enden ist dabei senkrecht zur Erstreckungsrichtung der geradlinigen Kontaktabschnitte und parallel zur Anreihrichtung der in einer Reihe nebeneinander angeordneten Kontaktstifte 20.

Erkennbar ist weiterhin, dass die Kontaktstifte 20 mit Abwinkelungen so aneinander vorbeigeführt werden, dass die freien, zur Anbindung an eine Leiterplatte 82 vorgesehenen Enden ohne Kollision und unter Einhaltung der erforderlichen Luft- und Kriechstrecken aneinander vorbeigeführt werden und seitlich aus dem Kontaktträger 19 herausragen. Auf diese Weise kann seitlich an dem Kontaktträger 19 eine Leiterplatte 82 angebunden werden, die Bohrungen zur Aufnahme der freien Enden und Anlöten derselben an der Leiterplatte 82 hat.

Die Leiterplatte 82 würde sich dann in einer Ebene erstrecken, die einerseits durch die Richtung der geradlinigen Kontaktabschnitte der Kontaktstifte 20 und andererseits durch eine Richtung senkrecht zu dem geradlinigen Kontaktabschnitt und den freien Enden zur Anbindung an der Leiterplatte 82 aufgespannt wird.

Erkennbar ist weiterhin, dass die freien Enden zur Anbindung an der Leiterplatte 82 mit mindestens jeweils einem Auflagebereich 43 auf einem zugeordneten Auflagesockel 44 aufliegen. Die Auflagesockel 44 können z.B. an einem Trennsteg des Kontaktträgers 19 ausgebildet sein. Der Auflagesockel 44 kann beispielsweise eine teilkreisförmige Vertiefung sein, in die der jeweilige Kontaktstift 20 dann von unten in Richtung Plattform 42 eingelegt wird. An der Seite, die der Plattform 42 gegenüberliegt, ist der Kontaktstift im Auflagebereich hingegen frei zugänglich, so dass die Kontaktstifte 20 von unten in den Kontaktträger 42 bei der Fertigung eingesetzt und im Kontaktträger 19 eingepresst oder gegebenenfalls verstemmt werden können.

Weiterhin ist erkennbar, dass an der Rückseite des Kontaktträgers 19 angrenzend an die Plattform 42 eine Führungswand 34 integral mit dem Kontaktträger 19 geformt ist. Die Führungswand 34 erstreckt sich parallel zu den geradlinigen Kontaktabschnitten und spannt eine Ebene auf, die parallel zu der von den geradlinigen Kontaktabschnitten der in einer Reihe nebeneinander aufgereihten geradlinigen Kontaktstifte 20 aufgespannt wird.

Zwischen den geradlinigen Kontaktabschnitten der Kontaktstifte 20 und der Führungswand 34 ist ein Freiraum vorhanden, so dass ein Leiteranschluss-Steckverbinder 6 mit Federkraftklemmkontakt unter Anlage an der Führungswand 34 auf die Kontaktstifte 20 aufgesteckt werden kann. Die Führungswand 34 kann optimal zur Aufnahme von Codierelementen ausgebildet sein, die dazu dienen nur zulässige Leiteranschluss-Steckverbinder 6 in einer zulässigen Orientierung einstecken zu können.

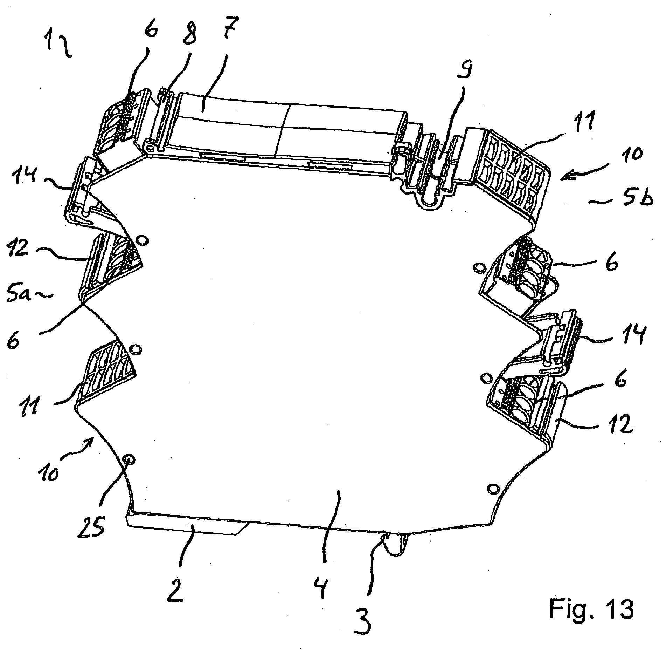

Figur 13 lässt eine perspektivische Ansicht eines Elektronikgerätegehäuses 1 in einer etwas anderen Zusammenstellung erkennen. Erkennbar ist, dass an der rechten Stirnseite 5b am oberen Montageplatz 10 nunmehr ein Blindkappenelement 11 eingesetzt ist. An dem darunter liegenden Montageplatz ist ein Auswerferelement 14 vorgesehen, um einen Leiteranschluss-Steckverbinder 6 lösbar einstecken zu können. Auf der unteren Ebene ist ein Verriegelungselement 12 zur fest verriegelten Aufnahme eines Leiteranschluss-Steckverbinders 6 vorhanden.

Auf der linken Stirnseite hingegen befindet sich an dem unteren Montageplatz 10, d.h. auf der untersten Ebene, ein Blindkappenelement 11. Darüber ist ein Verriegelungselement 12 zur fest verriegelten Aufnahme eines Leiteranschluss-Steckverbinders 6 vorgesehen.

Am oberen Montageplatz 10 ist hingegen ein verschwenkbares Auswerferelement 14 zur lösbaren Aufnahme eines Leiteranschluss-Steckverbinders 6 eingebracht.

Hierdurch wird deutlich, dass die einzelnen Montageplätze 10 je nach Bedarf mit Auswerferelementen 14, Verriegelungselementen 12 oder Blindkappenelementen 11 versehen werden können und damit die Montageplätze wahlweise mit Leiteranschluss-Steckverbindern 6 bestückbar oder im Falle von Blindkappenelementen 11 nicht bestückbar sind.

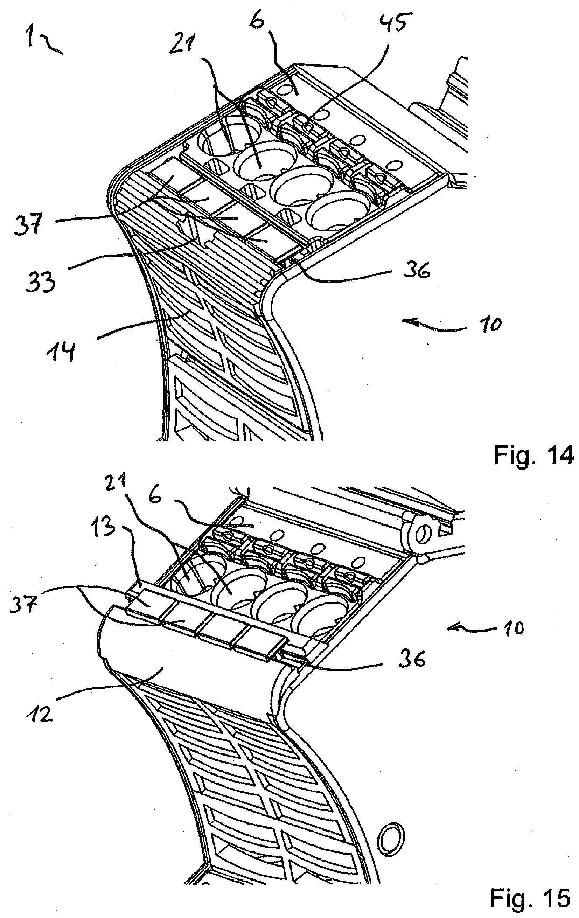

Die Figur 14 lässt eine perspektivische Ausschnittsansicht eines Elektronikgerätegehäuses 1 im Bereich eines Leiteranschluss-Steckverbinders 6 erkennen, der mit einem verschwenkbaren Auswerferelement 14 lösbar an dem Montageplatz 10 aufgenommen ist. Deutlich wird, dass der Leiteranschluss-Steckverbinder vier nebeneinander angeordnete Leitereinführungsöffnungen 21 sowie für jede Leitereinführungsöffnung einen Betätigungsdrücker 45 zum Öffnen einer im Innenraum angeordneten Klemmfeder und Lösen eines elektrischen Leiters hat.

Erkennbar ist weiterhin, dass jeder Leitereinführungsöffnung jeweils ein Beschriftungselement 37 zugeordnet ist. Die Beschriftungselemente 37 sind in eine Rastnut 36 an der Oberseite des Auswerferelementes 14 eingeclipst.

Figur 15 lässt eine entsprechende Darstellung mit einem Verriegelungselement 12 erkennen. Deutlich wird hierbei, dass an dem Kragen 13, der den Leiteranschluss-Steckverbinder 16 übergreift und im Montageplatz 10 sichert, eine Rastnut 36 eingebracht ist. In diese Rastnut 36 sind wiederum für jede Leitereinführungsöffnung 21 jeweils ein Beschriftungselement 37 eingeclipst.

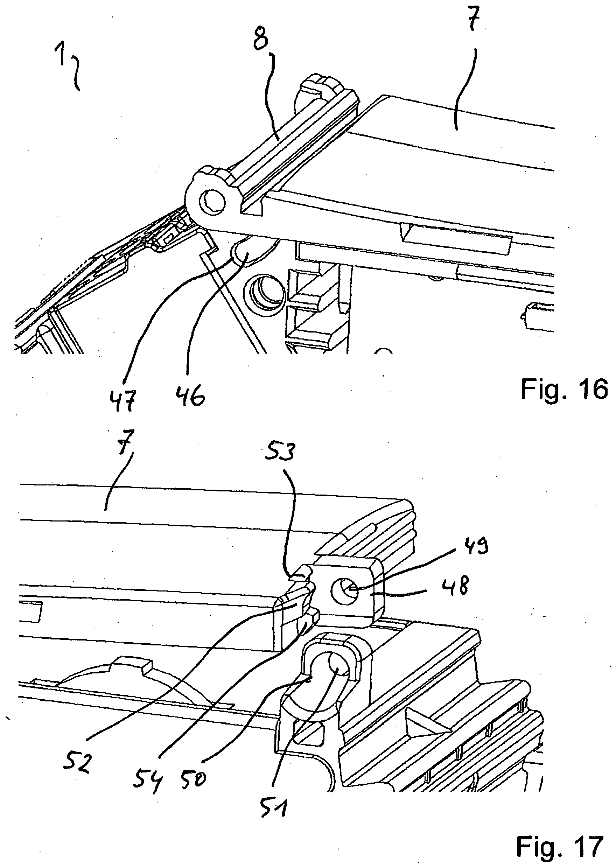

Figur 16 lässt eine perspektivische Ausschnittsdarstellung des Elektronikgerätegehäuses 1 im Bereich des Deckelelementes 7 erkennen. Deutlich wird, dass unterhalb des Schwenklagers an dem Deckelelement 7 ein gekrümmter Verriegelungszapfen 46 angeformt ist, der in der dargestellten Schließposition in eine Verriegelungszapfen-Aufnahmeöffnung 47 eintaucht. Mit Hilfe dieses Verriegelungszapfens 46 wird der Deckel 7 vor einem unzulässigen Heraushebeln nach oben geschützt. Dann bildet nämlich der Verriegelungszapfen 46 mit der Verriegelungszapfen-Aufnahmeöffnung 47 einen Anschlag.

Um das Deckelelement 7 an dem Elektronikgerätegehäuse 1 zu sichern und zu verplomben ist am vorderen, freien Ende des Deckelelementes ein Materiallappen 48 mit einer Öffnung 49 vorgesehen (siehe Figur 17). Angrenzend hieran ragt von dem Elektronikgerätegehäuse eine Öse 50 ebenfalls mit einer Öffnung 51 hervor. Wenn das Deckelelement 7 in Schließposition ist, fluchten die Öffnungen 49 und 51 und es kann ein Sicherungsband oder Sicherungsdraht zur Plombierung oder gegebenenfalls ein Vorhängeschloss durch die Öffnung 49, 51 geführt werden. Damit ist das Deckelelement 7 auch mit Hilfe der Verriegelungszapfen 46 manipulationssicher an dem Elektronikgerätegehäuse 1 befestigt.

Das Deckelelement 7 wird weiterhin noch dadurch gesichert, dass im Abstand zu dem Materiallappen 48 eine Führungsnase 52 zur Bildung einer Führungsnut 53 hervorsteht. Beim Herunterschwenken des Deckelelementes 7 taucht die Öse 50 teilweise in diese Führungsnut 53 ein. Mit Hilfe der Führungsnase 52 wird verhindert, dass das Deckelelement 7 seitlich verschoben wird.

Unterhalb der Führungsnase 52 ragt eine Rastnase 54 hervor, die mit der Öse 50 verrastet und das Deckelelement 7 in der Schließposition am Elektronikgerätegehäuse 1 sichert.

## Patentansprüche

1. Elektronikgerätegehäuse (1) und Set von Zubehörteilen umfassend Auswerferelemente (14) und Verriegelungselemente (12), wobei das Elektronikgerätegehäuse (1) zwei voneinander beabstandete Seitenwandelemente (4) zur Bildung eines Gehäuses mit einem Gehäuseinnenraum zur Aufnahme mindestens einer Leiterplatte (32) hat, und wobei an mindestens einer der Stirnseiten (5a, 5b) im Zwischenraum zwischen den Seitenwandelementen (4) mindestens ein Montageplatz (10) für Leiteranschluss-Steckverbinder (6) vorgesehen ist, **dadurch gekennzeichnet, dass** das Elektronikgerätegehäuse (1) im Bereich des mindestens einen Montageplatzes (10) Aufnahmeeinrichtungen (15, 23, 24) hat, die zur wahlweisen Aufnahme
- eines mittels der Aufnahmeeinrichtungen (15, 23, 24) verschwenkbar an dem Elektronikgerätegehäuse (1) lagerbaren Auswerferelementes (14) des vorgenannten Sets zum Auswerfen eines Leiteranschluss-Steckverbinders (6) aus einem Montageplatz (10) oder
- eines mittels der Aufnahmeeinrichtungen (15, 23, 24) fest an dem Elektronikgerätegehäuse (1) verrastbarem Verriegelungselement (12) des vorgenannten Sets zum Verriegeln eines Leiteranschluss-Steckverbinders (6) an einem Montageplatz (10), wobei mittels der Aufnahmeeinrichtungen (15, 23, 24) ein Verschwenken des fest verrastet aufgenommenen Verriegelungselementes (12) sicher verhindert wird.
ausgebildet sind.

2. Elektronikgerätegehäuse (1) nach Anspruch 1, **dadurch gekennzeichnet, dass** die Aufnahmeeinrichtungen (15, 23, 24) weiterhin zur wahlweisen Aufnahme eines mittels der Aufnahmeeinrichtungen (15, 23, 24) fest an den Seitenwandelementen (4) verrastbaren Blindkappenelementes (11) zur Abdeckung eines freien, nicht zur Aufnahme eines Leiteranschluss-Steckverbinders (6) vorgesehenen Montageplatzes (10) vorgesehen sind.

3. Elektronikgerätegehäuse (1) nach Anspruch 1 oder 2, **dadurch gekennzeichnet, dass** im Bereich der Montageplätze (10) sich quer zu den Seitenwandelementen (4) an einer jeweiligen Stirnseite (5a, 5b) erstreckende Zwischenwandabschnitte vorgesehen sind und diese Zwischenwandabschnitte eine freie Oberkante mit einer Lagernut (23) zur Aufnahme einer Lagerachse (25) eines Auswerferelementes (14), Verriegelungselementes (12) oder Blindkappenelementes (11) haben.

4. Elektronikgerätegehäuse (1) nach Anspruch 3, **dadurch gekennzeichnet, dass** an den Seitenwandelementen (4) fluchtend mit der Lagernut (23) Öffnungen (24) zur Aufnahme von freien Enden einer Lagerachse (25) vorgesehen sind.

5. Elektronikgerätegehäuse (1) nach Anspruch 1 oder 2, **dadurch gekennzeichnet, dass** im unteren Bereich der Montageplätze (10) an den Seitenwandelementen (4) jeweils einander gegenüberliegende Paare von Öffnungen (24) zur Aufnahme von freien Enden einer jeweils zugeordneten Lagerachse (25) eines Auswerferelementes (14), Verriegelungselementes (12) oder Blindkappenelementes (11) vorgesehen sind.

6. Elektronikgerätegehäuse (1) nach einem der vorhergehenden Ansprüche, **dadurch gekennzeichnet, dass** im oberen Bereich der Montageplätze (10) von den Seitenwandelementen (4) Rastzapfen (15) in den Zwischenraum zwischen den beiden Seitenwandelementen (4) hineinragen, wobei die Rastzapfen (15) wahlweise zur Verrastung eines schwenkbar am Elektronikgerätegehäuse (1) gelagerten Auswerferelementes (14) durch Eintauchen mindestens eines Rastzapfens (15) in eine Rastöffnung (16) am Auswerferelement (14) oder zum Festlegen eines Verriegelungselementes (12) oder Blindkappenelementes (11) durch Eintauchen in eine umlaufend geschlossene Bohrung (26) im Verriegelungselement (12) oder Blindkappenelement (11) vorgesehen sind.

7. Elektronikgerätegehäuse (1) nach einem der vorhergehenden Ansprüche, **dadurch gekennzeichnet, dass** im oberen Bereich der Montageplätze (10) in den Seitenwandelementen (4) Öffnungen zur Aufnahme von seitlich von einem Auswerferelement (14) vorstehenden Rastnasen oder seitlich von einem Verriegelungselement (12) oder Blindkappenelement (11) vorstehenden oder in diese über die Öffnungen in den Seitenwandelementen (4) von außen fest einsteckbaren Verriegelungsstiften vorgesehen sind.

8. Elektronikgerätegehäuse (1) nach einem der vorhergehenden Ansprüche, **dadurch gekennzeichnet, dass** im unteren Bereich eine Bodenplatte (2) mit einem Tragschienenrastfuß (3) zum Aufrasten des Elektronikgerätegehäuses (1) auf einer Tragschiene vorgesehen ist.

9. Elektronikgerätegehäuse (1) nach einem der vorhergehenden Ansprüche, **dadurch gekennzeichnet, dass** im oberen Bereich mindestens eine gekrümmte Verriegelungszapfen-Aufnahmeöffnung (47) zur Aufnahme jeweils eines zugeordneten Verriegelungszapfens (46), der von einem Deckelelement (7) abragt, vorgesehen ist.

10. Elektronikgerätegehäuse (1) nach einem der vorhergehenden Ansprüche, **dadurch gekennzeichnet, dass** im unteren Bereich von Montageplätzen (10) wahlweise Kontaktträger (19) mit Kontaktstiften (20) einbringbar sind, wobei die Kontaktstifte (20) mit einem freien Ende zur Kontaktierung mit einer in den Innenraum des Elektronikgerätegehäuses (1) einbringbaren Leiterplatte (32) und mit dem jeweils anderen freien Ende als Gegenkontakt für einen in den Montageplatz (10) einsteckbaren Leiteranschluss-Steckverbinder (6) ausgerichtet sind.

11. Elektronikgerätegehäuse (1) nach einem der vorhergehenden Ansprüche mit mindestens einem Auswerferelement (14), das benachbart zu einer Lagerachse (25) mindestens einen vorstehenden Finger (29) hat, wobei das Auswerferelement (14) so ausgebildet ist, dass der mindestens eine Finger (29) im schwenkbar an den Aufnahmeeinrichtungen des Elektronikgerätegehäuses (1) eingebautem Zustand einen an einem zugeordneten Montageplatz (10) eingesteckten Leiteranschluss-Steckverbinder (6) untergreift, um diesen durch Verschwenken des Auswerferelementes (14) aus dem Montageplatz (10) auszuwerfen.

12. Elektronikgerätegehäuse (1) nach einem der vorhergehenden Ansprüche, mit mindestens einem Verriegelungselement (12), das an einer freien Oberkante mindestens einen vorstehenden Kragen (13) hat, wobei der Kragen (13) so angepasst ist, dass in der an einem Montageplatz (10) am Elektronikgerätegehäuse (1) verrasteten Position ein in diesen Montageplatz (10) eingesteckter Leiteranschluss-Steckverbinder (6) von dem Kragen (13) übergriffen und vor Entnahme aus dem Montageplatz (10) gesichert wird.

## Claims

1. An electronics device housing (1) and a set of accessory parts comprising elements (14) and locking elements (12) wherein the electronic device housing (1) having two side wall elements (4), which are spaced apart from one another, for forming a housing having a housing interior for receiving at least one printed circuit board (32), wherein at least one fitting location (10) for conductor connection plug connectors (6) is provided on at least one of the end sides (5a, 5b) in the intermediate space between the side wall elements (4), **characterized in that** the electronics device housing (1) has receiving devices (15, 23, 24) in the region of the at least one fitting location (10), said receiving devices being designed to selectively receive
- an ejector element (14) of the aforementioned set, which can be pivotably mounted on the electronics device housing (1) by means of the receiving devices (15, 23, 24), for ejecting a conductor connection plug connector (6) from a fitting location (10), or
- a locking element (12) of the aforementioned set, which can be fixedly latched to the electronics device housing (1) by means of the receiving devices (15, 23, 24), for locking a conductor connection plug connector (6) at a fitting location (10), wherein by means of the receiving devices (15, 23, 24) the fixedly latched locking element (12) is reliably prevented from pivoting.

2. The electronics device housing (1) as claimed in claim 1, **characterized in that** the receiving devices (15, 23, 24) are also intended to selectively receive a blind cap element (11), which can be fixedly latched to the side wall elements (4) by means of the receiving devices (15, 23, 24), for covering a free fitting location (10) not intended to receive a conductor connection plug connector (6).

3. The electronics device housing (1) as claimed in claim 1 or 2, **characterized in that** intermediate wall portions are provided in the region of the fitting locations (10) in a manner extending transversely to the side wall elements (4) on a respective end side (5a, 5b), and these intermediate wall portions have a free upper edge with a bearing groove (23) for receiving a bearing shaft (25) of an ejector element (14), locking element (12) or blind cap element (11).

4. The electronics device housing (1) as claimed in claim 3, **characterized in that** openings (24) for receiving free ends of a bearing shaft (25) are provided on the side wall elements (4), in line with the bearing groove (23).

5. The electronics device housing (1) as claimed in claim 1 or 2, **characterized in that** mutually opposed pairs of openings (24) for receiving free ends of an associated bearing shaft (25) of an ejector element (14), locking element (12) or blind cap element (11) are provided in the lower region of the fitting locations (10) on the side wall elements (4).

6. The electronics device housing (1) as claimed in one of the preceding claims, **characterized in that** latching journals (15) protrude in the upper region of the fitting locations (10) from the side wall elements (4) into the intermediate space between the two side wall elements (4), wherein the latching journals (15) are intended selectively to latch an ejector element (14), mounted pivotably on the electronics device housing (1), by plunging of at least one latching journal (15) into a latching opening (16) on the ejector element (14) or to fix a locking element (12) or blind cap element (11) by plunging into a peripherally closed bore (26) in the locking element (12) or blind cap element (11).

7. The electronics device housing (1) as claimed in one of the preceding claims, **characterized in that** openings for receiving latching lugs protruding laterally from an ejector element (14) or locking pins which protrude laterally from a locking element (12) or blind cap element (11) or which can be plugged fixedly from outside thereinto via the openings in the side wall elements (4) are provided in the upper region of the fitting locations (10) in the side wall elements (4).

8. The electronics device housing (1) as claimed in one of the preceding claims, **characterized in that** a base plate (2) with a mounting rail latching foot (3) for latching the electronics device housing (1) onto a mounting rail is provided in the lower region.

9. The electronics device housing (1) as claimed in one of the preceding claims, **characterized in that** at least one curved locking journal receiving opening (47) for receiving an associated locking journal (46), which protrudes from a cover element (7), is provided in the upper region.

10. The electronics device housing (1) as claimed in one of the preceding claims, **characterized in that** contact carriers (19) with contact pins (20) can be selectively introduced in the lower region of fitting locations (10), wherein the contact pins (20) are oriented with a free end for contacting a printed circuit board (32), which can be introduced into the interior of the electronics device housing (1), and with the other free end as a mating contact for a conductor connection plug connector (6), which can be plugged into the fitting location (10).

11. The electronics device housing (1) as claimed in one of the preceding claims, having at least one ejector element (14), which has at least one protruding finger (29) adjacent to a bearing shaft (25), wherein the ejector element (14) is formed such that the at least one finger (29), when pivotably installed on the receiving devices of the electronics device housing (1), engages below a conductor connection plug connector (6) plugged in at an associated fitting location (10) so as to eject said conductor connection plug connector from the fitting location (10) by pivoting the ejector element (14).

12. The electronics device housing (1) as claimed in one of the preceding claims, having at least one locking element (12), which has at least one protruding collar (13) on a free upper edge, wherein the collar (13) is adapted such that, in the position latched on a fitting location (10) on the electronics device housing (1), the collar (13) engages over a conductor connection plug connector (6) plugged into this fitting location (10) and said connector is secured against removal from the fitting location (10).

## Revendications

1. Boîtier d'appareil électronique (1) et un ensemble d'accessoires comprenant des éléments d'éjection (14) et des éléments de verrouillage (12) dans le boîtier d'appareil électronique (1) comportant des éléments de parois latérales (4) espacés les uns des autres pour former un boîtier ayant un espace intérieur de boîtier destiné à recevoir au moins une carte de circuit imprimé (32), dans lequel au moins un emplacement de montage (10) est prévu pour des connecteurs de raccordement de conducteurs (6) sur au moins une face avant (5a, 5b) dans l'espace intermédiaire situé entre les éléments de parois latérales (4), **caractérisé en ce que** le boîtier d'appareil électronique (1) comporte, dans la région de l'au moins un emplacement de montage (10), des dispositifs de réception (15, 23, 24) qui sont conçus pour recevoir sélectivement
- un élément d'éjection (14) de l'ensemble susmentionné pouvant être monté de manière pivotante sur le boîtier d'appareil électronique (1) au moyen des dispositifs de réception (15, 23, 24) pour éjecter un connecteur de raccordement de conducteur (6) hors de l'emplacement de montage (10), ou
- un élément de verrouillage (12) de l'ensemble susmentionné pouvant être encliqueté de manière rigide sur le boîtier d'appareil électronique (1) au moyen des dispositifs de réception (15, 23, 24) pour verrouiller un connecteur de raccordement de conducteur (6) sur un emplacement de montage (10), dans lequel le pivotement de l'élément de verrouillage (12), qui es reçu d'une manière fermement verrouillée. Es empêché de manière fiable au moyen des dispositifs de réception (15, 23, 24) .

2. Boîtier d'appareil électronique (1) selon la revendication 1, **caractérisé en ce que** les dispositifs de réception (15, 23, 24) sont en outre prévus pour recevoir sélectivement un élément formant bouchon aveugle (11) pouvant être encliqueté de manière rigide sur les éléments de parois latérales (4) au moyen des dispositifs de réception (15, 23, 24) pour recouvrir un emplacement de montage (10) libre non prévu pour recevoir un connecteur de raccordement de conducteur (6).

3. Boîtier d'appareil électronique (1) selon la revendication 1 ou 2, **caractérisé en ce que**, dans la région des emplacements de montage (10), il est prévu des sections de parois intermédiaires s'étendant transversalement aux éléments de parois latérales (4) sur une face avant respective (5a, 5b) et lesdites sections de parois intermédiaires comportent un bord supérieur libre ayant une gorge de palier (23) destinée à recevoir un axe de palier (25) d'un élément d'éjection (14), d'un élément de verrouillage (12) ou d'un élément formant bouchon aveugle (11).

4. Boîtier d'appareil électronique (1) selon la revendication 3, **caractérisé en ce qu'**il est prévu des ouvertures (24) destinées à recevoir des extrémités libres d'un axe de palier (25) sur les éléments de parois latérales (4) en alignement avec la gorge de palier (23).

5. Boîtier d'appareil électronique (1) selon la revendication 1 ou 2, **caractérisé en ce qu'**il est prévu dans la région inférieure de l'emplacement de montage (10) des paires respectives mutuellement opposées d'ouvertures (24) destinées à recevoir des extrémités libres d'un axe de palier (25) respectif associé d'un élément d'éjection (14), d'un élément de verrouillage (12) ou d'un élément formant bouchon aveugle (11) sur les éléments de parois latérales (4).

6. Boîtier d'appareil électronique (1) selon l'une quelconque des revendications précédentes, **caractérisé en ce que** des broches d'encliquetage (15) font saillie dans l'espace intermédiaire entre les deux éléments de parois latérales (4) dans la région supérieure des emplacements de montage (10) des éléments de parois latérales (4), dans lequel les broches d'encliquetage (15) sont prévues sélectivement pour encliqueter un élément d'éjection (14) monté pivotant sur le boîtier d'appareil électronique (1) par insertion d'au moins une broche d'encliquetage (15) dans une ouverture d'encliquetage (16) sur l'élément d'éjection (14) ou pour fixer un élément de verrouillage (12) ou un élément formant bouchon aveugle (11) par insertion dans un alésage périphérique fermé (26) dans l'élément de verrouillage (12) ou l'élément formant bouchon aveugle (11).

7. Boîtier d'appareil électronique (1) selon l'une quelconque des revendications précédentes, **caractérisé en ce qu'**il est prévu dans les éléments de parois latérales (4), dans la région supérieure des emplacements de montage (10), des ouvertures destinées à recevoir des ergots d'encliquetage faisant saillie latéralement par rapport à un élément d'éjection (14) ou des tiges de verrouillage faisant saillie latéralement par rapport à un élément de verrouillage (12) ou à un élément formant bouchon aveugle (11) ou pouvant être enfichées de manière rigide depuis l'extérieur dans celles-ci par l'intermédiaire des ouvertures ménagées dans les éléments de parois latérales (4).

8. Boîtier d'appareil électronique (1) selon l'une quelconque des revendications précédentes, **caractérisé en ce qu'**il est prévu dans la région inférieure une plaque de fond (2) ayant un pied d'enclenchement de rail de support (3) destiné à enclencher le boîtier d'appareil électronique (1) sur un rail de support.

9. Boîtier d'appareil électronique (1) selon l'une quelconque des revendications précédentes, dans lequel il est prévu dans la région supérieure au moins une ouverture de réception de broche de verrouillage incurvée (47) destinée à recevoir une broche de verrouillage (46) associée respective qui dépasse d'un élément de couvercle (7) .

10. Boîtier d'appareil électronique (1) selon l'une quelconque des revendications précédentes, **caractérisé en ce que** des supports de contact (19) ayant des tiges de contact (20) peuvent être insérés sélectivement dans la région inférieure des emplacements de montage (10), dans lequel les tiges de contact (20) sont agencées de manière à ce qu'une extrémité libre vienne au contact d'une carte de circuit imprimé (32) pouvant être insérée dans l'espace intérieur du boîtier d'appareil électronique (1) par l'autre extrémité libre respective joue le rôle de contre-contact pour un connecteur de raccordement de conducteur (6) pouvant être enfiché dans l'emplacement de montage (10).

11. Boîtier d'appareil électronique (1) selon l'une quelconque des revendications précédentes, comportant au moins un élément d'éjection (14) qui comporte au moins un doigt (29) faisant saillie de manière adjacente à un axe de palier (25), dans lequel l'élément d'éjection (14) est réalisé de manière à ce que l'au moins un doigt (29), à l'état inséré de manière pivotante sur les dispositifs de réception du boîtier d'appareil électronique (1), vienne en prise par le dessous avec un connecteur de raccordement de conducteur (6) enfiché dans un emplacement de montage (10) associé afin d'éjecter ce dernier par pivotement de l'élément d'éjection (14) hors de l'emplacement de montage (10).

12. Boîtier d'appareil électronique (1) selon l'une quelconque des revendications précédentes, comportant au moins un élément de verrouillage (12) qui comporte au moins un collier (13) faisant saillie sur un bord supérieur libre, dans lequel le collier (13) est ajusté de manière à ce que, à la position encliquetée dans un emplacement de montage (10) sur le boîtier d'appareil électronique (1), un connecteur de raccordement de conducteur (6) enfiché dans ledit emplacement de montage (10) soit mis en prise par le haut avec le collier (13) et soit fixé avant de sortir de l'emplacement de montage (10).
